**Europäisches Patentamt**

**European Patent Office**

**Office européen des brevets**

(11) Publication number: **0 031 539**
**B1**

(12) **EUROPEAN PATENT SPECIFICATION**

(45) Date of publication of patent specification: **25.03.87**

(21) Application number: **80107938.5**

(22) Date of filing: **16.12.80**

(51) Int. Cl.⁴: **H 01 L 23/52**

(54) **Voltage distribution system of an LSI chip.**

(30) Priority: **28.12.79 US 108074**

(43) Date of publication of application:
**08.07.81 Bulletin 81/27**

(45) Publication of the grant of the patent:
**25.03.87 Bulletin 87/13**

(84) Designated Contracting States:
**DE FR GB**

(56) References cited:

**IBM TECHNICAL DISCLOSURE BULLETIN, vol.
22, no. 3, August 1979, pages 1240-1244, New
York, US, V.L. RIDEOUT: "Polysilicon BIT line"**

**IBM TECHNICAL DISCLOSURE BULLETIN, vol.
21, no. 6, November 1978, pages 2262-2263,
New York, US, R.A. UNIS: "Charge-coupled
device dynamic memory cell"**

(73) Proprietor: **International Business Machines
Corporation
Old Orchard Road
Armonk, N.Y. 10504 (US)**

(72) Inventor: **De La Moneda, Francisco H.
15 Nathan Hale Drive
Stormville New York 12582 (US)**
Inventor: **Williams, Thomas A.
10806 Hunt Club Road
Reston Virginia 22090 (US)**

(74) Representative: **Kreidler, Eva-Maria, Dr. rer. nat.
Schönaicher Strasse 220
D-7030 Böblingen (DE)**

Courier Press, Leamington Spa, England.

## Description

The invention relates to a voltage distribution system of an LSI chip.

A major obstacle which has confronted the prior art in improving the performance of large MOSFET arrays is the resistance of interconnection paths or buses to ground potential when they are implemented using state-of-the-art diffused or polycrystalline lines. The ohmic resistance of these lines causes an inverse relationship between the array size and its circuit performance parameters such as access time, noise tolerance, and temperature operating range. As the array size increases, the design of its cells and support circuits has to be compromised in order to account for resistance induced ground shifts which cause random malfunctioning. The prior art has proposed low resistance buses to distribute power and ground to large scale integrated (LSI) circuitry. For instance, US—A—3,808,475 discloses the addition of a metallic level for the sole purpose of distributing ground potential to circuit "macros". This is typical of the approach often used by the prior art, particularly in the case of bipolar LSI. This approach is expensive because of the fabrication cost of an extra metallic level and reductions in manufacturing yield by electrical shorts to other power distribution levels.

Thus, there is an economic incentive to solutions of the ground resistance problem that can be implemented without increasing the fabrication cost of the improved LSI chip.

The object of the invention is a voltage distribution structure, in particular a semiconductor ground distribution structure which substantially reduces the resistance to ground of devices belonging to an array and which can be implemented using one of already existing polysilicon layers in a MOSFET array.

The object of the invention is achieved by a voltage distribution system of an LSI chip according to claim 1.

An embodiment of the invention provides an improved large scale integrated LSI circuit structure and especially an improved voltage distribution bus for large scale arrays of integrated circuits. The performance of LSI chips is improved through the utilization of vertical structures. Furthermore an improved voltage distribution bus for MOSFET LSI chips is provided without increasing the complexity of their fabrication. The ground resistance problem is solved by capitalizing on already existing processes. Therefore, it is cost effective. By taking advantage of the improved voltage distribution network a read only memory (ROM) array can be devised.

The objects, features and advantages of the invention are accomplished by a polycrystalline silicon (polysilicon) layer structure which comes into direct contact with the terminals or electrodes of devices embedded in a semiconductor chip. Advantage is taken of one of the conductive polysilicon layers produced by conventional double-layer polysilicon processes to construct said structure in a grid-like pattern. This conductive grid distributes ground potential from grounded pads on the chip periphery to internal devices. These devices are usually disposed in an array format. In one form, said grid sections the chip into a multitude of rectangular cells, not necessarily of equal linear dimensions, each cell encompassing one or more array devices. Device regions to be grounded are directly contacted by the columns and/or rows of said grid so as to efficiently use chip area.

One application of the disclosed ground distribution grid is to MOSFET ROM arrays fabricated using two layers of polysilicon. Each MOSFET of such array has a drain, source and gate region. For efficient use of the chip area, the drain and source regions of adjacent devices are usually merged. In the array, these merged drain and source regions are respectively connected between an output or sense line and ground at the point where a word line connected to gate regions crosses an output line. Whence, ROM array devices are sometimes referred to as crosspoints. ROM arrays permanently store words which are composed of binary bits. The binary contents of a ROM are written into its array by altering the conduction parameters of the MOSFET crosspoints during fabrication and involving only one masking operation. A convenient alteration is raising the MOSFET threshold voltage to prevent it from switching out of its output state in response to execution by its word line. Conversely, switching to the complementary output state is obtained from those MOSFETs with unaltered threshold voltage. In order to select a word line and read information out of the array, addressing, decoding and sensing MOSFET circuits are included on the chip, peripheral to the array. They are commonly referred to as support circuits.

Array MOSFETs are compactly disposed, chain-like, in elongated row regions. Within a row, successive gate regions have alternatively disposed therebetween drain and source regions which are then common to every pair of successive gates. To avoid ambiguous switching signals at said common drain regions, each gate region within a row is connected to a distinct word line whose other bit-storing crosspoint MOSFETs are located at the same location in the remaining rows of the array.

The proposed ground grid is incorporated into the herein above ROM organization by advantageous modifications of the conventional double-polysilicon processes used in fabricating one-transistor (1-T) memory cells. The essential modification is the addition of an extra masking-etching operation to open periodically disposed holes in oxide covered row regions. Then, doping impurities provided by the subsequently deposited first-polysilicon layer diffuse therethrough and thereby form source regions in direct contact with the ground distribution grid which is etched out of said first-polysilicon layer. After appropriate thicknesses of isolating and gate

oxide layers have been formed, a second polysilicon layer is deposited and etched to produce word lines orthogonally crossing said rows and forming therein gate regions over said gate oxide layers. Then, as typically done in the fabrication of polysilicon-gate MOSFETs, self-aligned drain regions are formed in those gate oxide regions remaining uncovered. Finally, connections to the array and ground grid are completed. In the array, metal lines are disposed over each row, connecting all drain regions therein to output ports; while the periphery of the grid is connected to chip pads supplying ground potential.

These and other objects, features and advantages of the invention will be more fully appreciated with reference to the accompanying figures.

Figures 1A—1D are cross-sectional views of the proposed ground distribution structure shown connected to a row of MOSFET ROM array in various stages of fabrication by a double polysilicon process.

Figure 1E shows a top view of the proposed ground distribution structure.

Figures 1F—1H show cross-sectional views of the final fabrication stages leading to the completion of a MOSFET ROM array connected to the proposed ground distribution structure.

Figure 2 shows a cross-sectional view of the proposed ground distribution structure connected to a row of a MOSFET ROM array fabricated by an alternative double polysilicon process.

A semiconductor structure is described to distribute an externally supplied ground potential to a large number of MOSFET devices arranged in an array format on a LSI semiconductor chip. The structure consists of orthogonal lines, columns and rows, of conductive material, their intersections making contact to form an electrical grid. Electrodes of array MOSFETs that are to be grounded make direct contact to said columns, rows, or both, along their span while the end portion of the rows and columns, in turn, are contacted by metal buses extending from the chip ground pads. Hence, the total resistance between any contacted MOSFET and ground pads is the parallel combination of a plurality of cascading segments of columns and rows, and thus, any such MOSFET can be assumed to have a negligible resistance to ground and be free of noise or ground shifts. Array performance can then be enhanced without much regard for its size.

In what follows, the proposed ground distribution grid is implemented using a slightly modified double-polysilicon, self-aligned gate process as used in fabricating a type of one-transistor (1-T) memory cell for random-access memory (RAM) arrays. In this 1-T cell type, first- and second-deposited polysilicon layers respectively go into the making of the upper electrode of the storage capacitor and the gate region of the MOSFET switch. Process compatibility with double-polysilicon 1-T cells is another desirable feature of the proposed ground grid structure; particularly, in LSI chips requiring arrays of RAM and ROM. Then

in what follows, process compatibility of the ground grid preferred embodiment is illustrated with a ROM array simultaneously fabricated to benefit from that embodiment.

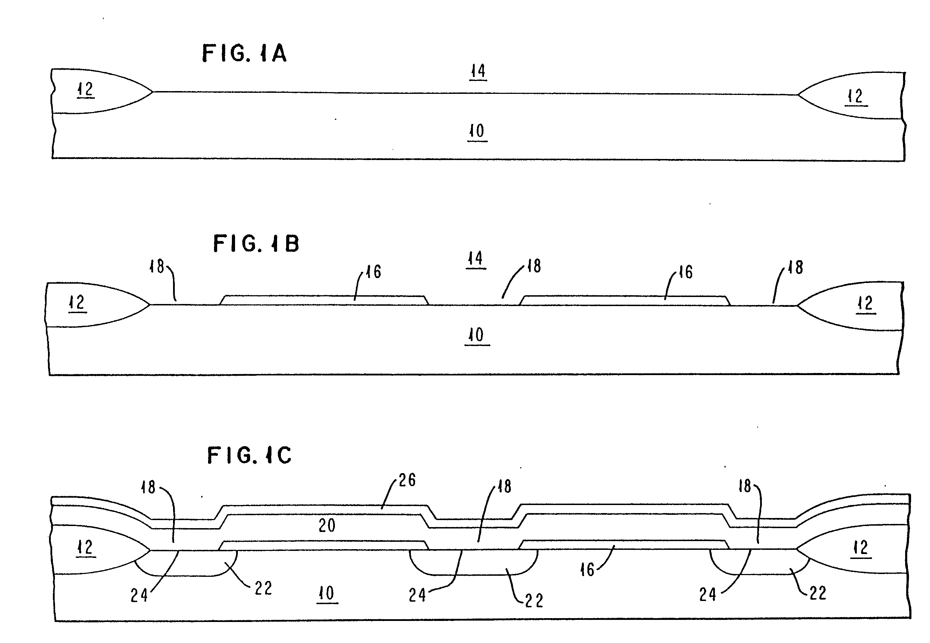

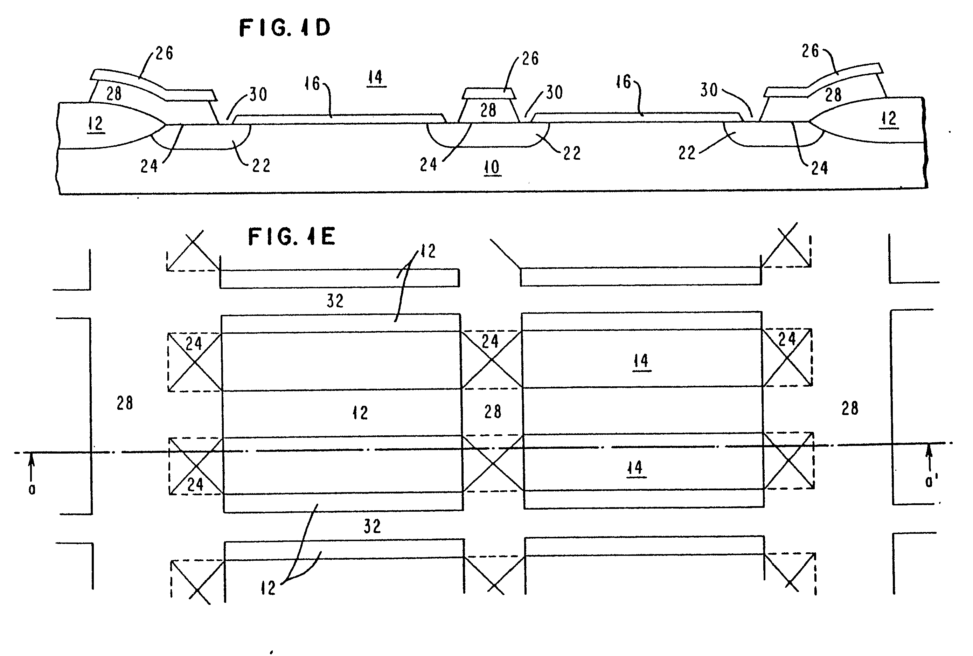

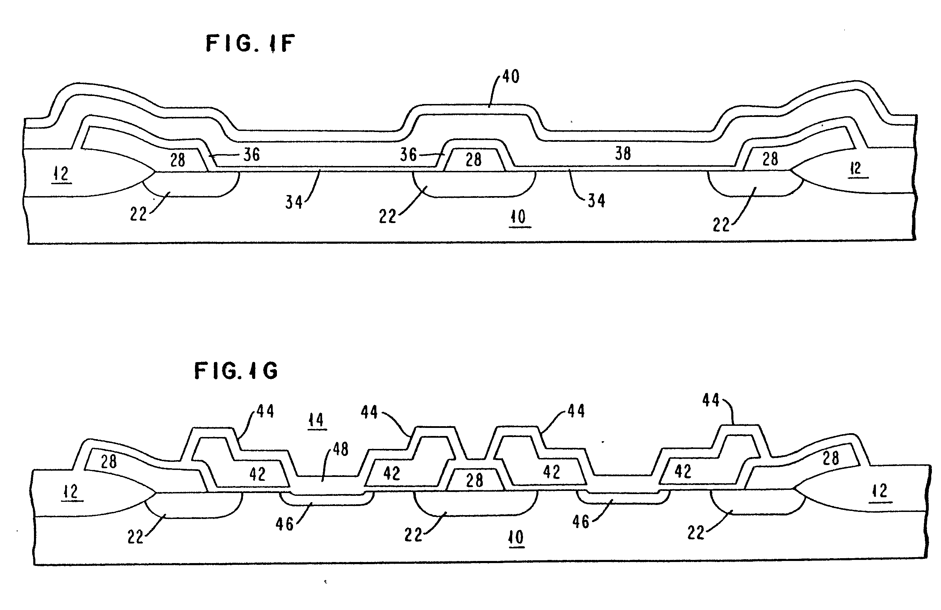

The illustrations of Figure 1 show cross-sectional views of the preferred embodiment as part of a composite grid-ROM structure during important stages in the fabrication thereof. It will be assumed that the semiconductor wafer is silicon of p-type conductivity, although the proposed grid is equally capable of distributing ground potential over n-type substrates.

With reference to Figure 1A, a p-type substrate 10 is depicted whose top surface has lost its initial planarity due to the formation of recessed thick oxide layers 12 obtained by well known masking, etching and oxidation techniques. Layers 12 partition the area of the ROM array into rectangular regions 14, elongated in one of the dimensions of the array, for instance the row dimension. Each long row region 14 is completely surrounded by layer 12 and thereby isolated from other neighboring rows or support circuitry on the array periphery. Within each one of these rows, crosspoint MOSFETs are to be located with all drain regions thereof connected to an output line, all source electrodes grounded, and each gate electrode connected to an individual word line. In the sequence of Figure 1, four crosspoint MOSFET's are included in row 14; although in actual arrays, upwards of 100 devices are contained therein.

Figure 1B shows the results of the first processing steps in preparation for constructing the preferred embodiment of the ground distribution grid. To start with, an oxide layer 16 is thermally grown to a thickness between 40 and 70 nm inside region 14. At this point, masking and etching operations of layer 16 are added to the conventional 1-T cell double-polysilicon process to open holes 18 wherever the ground grid is to contact the source region of the array MOSFETs. The boundaries of holes 18 are defined by the crossing of a mask determined rectangle with rows 14 so that holes 18 are walled by region 12 in the column direction.

Next, in Figure 1C, a first polysilicon layer 20 is deposited over the entire wafer. Layer 20 is somewhere between 300 and 500 nm thick and may be deposited by chemical-vapor deposition or evaporation. Layer 20 is now doped with n-type impurities such as arsenic, phosphorus, or antimony. A preferred choice is phosphorus from a deposited $POCL_3$ layer. The phosphorus makes layer 20 n-type and diffuses through holes 18 to form n-type regions 22 for the source electrodes of the array MOSFETs. Regions 22, having beeen formed after deposition of layer 20 are naturally self-aligned therewith for efficient use of the chip area. For instance, the contact areas 24 between layer 20 and source regions 22 extend across the full width of rows 14 inasmuch as holes 18 also do. This type of polysilicon-to-diffusion contact is commonly referred to as buried contact.

After depositing a 200 nm thick silicon oxide layer 26, a grid pattern is photoengraved on a layer of positive photoresist covering 26. The portions of 26 not protected by developed photoresist are removed in a bath of buffered hydrofluoric acid. With the grid pattern thus transferred to layer 26, the photoresist pattern is dissolved away and the etching of polysilicon layer 20 proceeds. Dry plasma etching of layer 20 is preferred since it can produce steeper sidewalls. A portion of the etched ground distribution grid is shown in the cross-sectional view of Figure 1D taken along the a—a' plane of the top view in Figure 1E. In Figure 1D, the contact areas 24 of grid columns 28 to source regions 22 are shown within the borders of holes 18 and spaced therefrom by a clearance region 30. Enough clearance 30 is left to insure a minimum overlamp between source regions 22 and corresponding gate regions to be subsequently formed out of the second polysilicon layer. As shown by the top view of Figure 1E, grid columns 28 interconnect all source regions 22 located at the same location in rows 14. In turn, columns 28 are interconnected by rows 32 disposed on the thick oxide layer 12, not necessarily at regular intervals. In accordance with the invention, total resistance to ground from a crosspoint on a given column is decreased by forming a multitude of parallel current paths to ground. These paths are provided by intersecting row lines 32 and the connections thereof to adjacent columns. The total array area may increase as rows 32 are added depending on various process specifications. These include alignment tolerance in transferring grid pattern from mask to wafer surface, etching and oxidation tolerances, and taper angle of polysilicon sidewalls.

To complete the proposed grid structure, it only remains to form contacts on its periphery whereon external ground potential is applied. Before reaching that point, the fabrication of the crosspoint and support circuit MOSFETs must continue as follows. The remaining portions of silicon oxide layer 16 are removed by dip etching in buffered hydrofluoric acid. Then, a thermal oxide growth forms a 50 nm thick gate insulator layer 34 over the exposed substrate surface and about four-times thicker layer 36 over exposed polysilicon surfaces, both shown in Figure 1F. Next, the maskless implantation of p-type doping ions is used to adjust the threshold voltage of all devices to meet circuit specifications. Typical parameters for this implant are $2 \times 10^{12}$ ions/cm$^2$ of B+ at 50 Kev. Additional implantation of selected crosspoint MOSFETs follows to permanently store in the array the binary contents of the ROM. The threshold voltage of those MOSFETs that are to store binary "0" is sufficiently raised to bring about a permanent "OFF" condition under the normal operating bias conditions of the array. The remaining array and support MOSFETs are masked against this implantation and therefore operate normally.

Next, a second polysilicon layer 38 is deposited to a thickness of about 400 nm and doped with n-type impurities using the same techniques mentioned in connection with layer 20. After doping, a layer 40 of silicon oxide, 200 to 300 nm thick, is grown or, preferably, deposited onto polysilicon layers 38 as shown in Figure 1F. Masking and etching of layers 38 and 40, as herein above described for layers 20 and 26, yields gate electrodes for MOSFETs in the area of support circuitry and word lines in the array. These word lines are disposed orthogonally to rows 14, in the column direction. Thus, they alternatively cover regions of thick oxide 12 and gate insulator 34, the latter portion forming gate regions 42 of the crosspoint MOSFETs shown in Figure 1G. As illustrated therein, polysilicon word lines 42 overlap adjacent ground grid columns 28 in the interest of reducing array area and facilitating gate-source overlap without needing a large clearance 30 in Figure 1D.

The wafer is then exposed to a maskless ion implantation to deposit sources of n-type dopant ions which after a thermal drive-in form diffused drain regions 46 in the array area, as shown in Figure 1G, and regions for the support circuit MOSFETs. During this thermal drive-in, an oxide layer 48, between 200 to 300 nm thick, grows over drain regions 46 and the sidewalls of the polysilicon word lines, 42.

Next, masking and etching operations provide contact holes to allow subsequent metallic connections to diffused drain-source regions and said first and second polysilicon layers in both the array and support circuitry area of the chip. In the case of the first polysilicon layer, a set of contact holes are located at the peripheral boundaries of the ground grid, preferably at both terminals of each one of its columns and rows. These holes are subsequently contacted by metallic bus lines extending from chip pads at ground potential. Thus, with ground potential supplied to all terminations of columns and rows, the grid potential distribution is multisymmetrical and, therefore, the total resistance to ground from any one array crosspoint is fairly independent of its location.

Next, the metallic-type interconnection material 52 of Figure 1H, preferably aluminum, is deposited and then etched to obtain lines interconnecting the contact holes previously opened. Lines 52, running over contact holes 50, interconnect all drain regions 46 in a given row to corresponding output ports of the array. On the outlying regions of the chip, lines are laid to interconnect array word lines and output ports to support circuits and pads.

While the invention has been particularly described and shown in its application to MOSFET ROM arrays, it will be understood that it is also applicable and beneficial to other types of arrays such as erasable programmable read-only memories, programmable logic arrays and shift registers. Furthermore, changes to the preferred embodiment and its fabrication may be made without departing from the scope of the invention. For instance, a ground distribution grid can be alternatively fabricated out of the second polysilicon layer and still maintain process compatibility with a type of 1-T cell wherein the first polysilicon layer provides the gate region of the MOSFET switch and the second polysilicon layer provides the upper electrode of the storage capacitor. Details on the fabrication and structure of this type of 1-T cell are taught by L. V. Rideout in US—A—4,075,045, assigned to IBM.

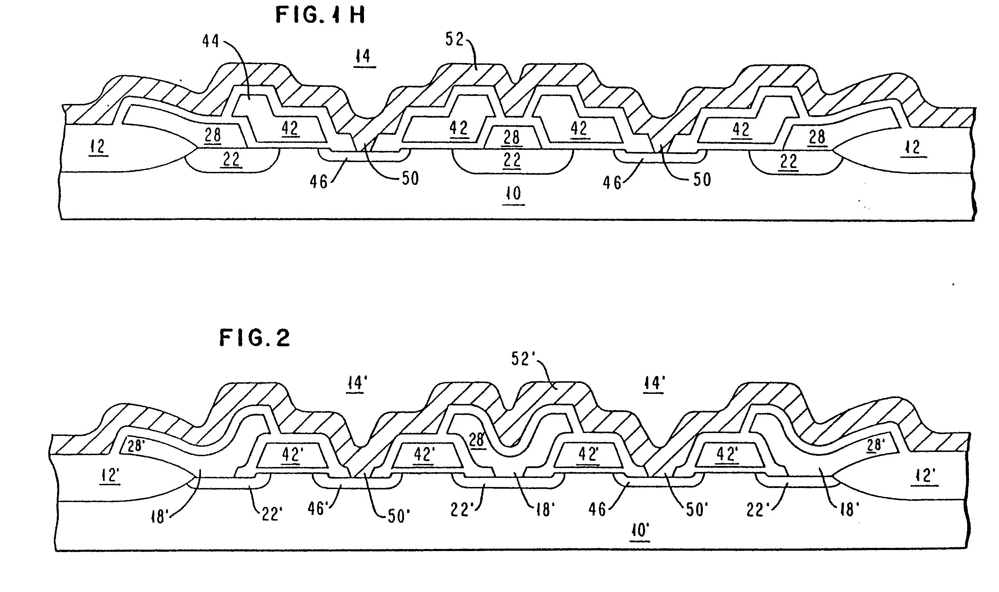

Figure 2 is a counterpart to Figure 1H, arrived at after following the major steps of the double polysilicon process taught by Rideout with some modifications. The reference numerals of the structural elements of Figure 1H have been primed for use on their counterparts of Figure 2. As in the fabrication sequence of Figure 1, the main deviation from the original 1-T process is the addition of one extra masking-etching operation. In this instance, these operations are used in opening holes 18' to allow the second polysilicon layer to come in direct contact with source regions 22'.

Unlike Figure 1, source regions 22' are diffused prior to the deposition of the ground-grid-forming second polysilicon layer. Consequently, the self-alignment obtained between columns 28 and source regions 22 in Figure 1 is missing from Figure 2. The tolerance associated with aligning holes 18' withinsource region 22' does not necessarily imply that rows 14' are more area-consuming than their counterparts 14 since the latter are impacted by the clearance regions 30 which are absent from the structure in Figure 2.

The use of polysilicon material as an interconnection medium and source of doping impurities in the fabrication of the preferred embodiment of our invention is also part of the art of making emitter regions for bipolar transistors as reported, for instance, by K. Okada, K. Aomura, M. Suzuki, and H. Shiba in "PSA — A New Approach for Bipolar LSI 693," *IEEE Journal of Solid-State Circuits*, Volume SC-13, October 1978, pp. 693—698. The making of such bipolar transistor yields polysilicon extensions self-aligned with respect to the emitter regions. Thus, arrays of such bipolar structures can economically incorporate the proposed ground distribution grid by applying the principles of the invention to said emitter-connected polysilicon layer.

## Claims

1. Voltage distribution system (28, 32) of an LSI chip where a body of semiconductor material (10) of the first conductivity type is embedded with first regions (22) of the second conductivity type, contiguous with the surface thereof, and covered by an insulating layer (12, 16) not necessarily of uniform thickness, said layer having holes (18) reaching said first regions (22), characterized in that said voltage distribution system disposed on said insulating layer (12) is composed of a number of polycrystalline semiconductor material columns (28) of the first conductivity type intersecting a set of polycrystalline semiconductor material rows (32), the number of columns and rows and their respective periodicities not being necessarily the same, and having metallic connections to perimeter pads, said rows (32) and columns (28) partially or completely covering said holes (18) so as to form an electrical contact with said first regions (22).

2. Voltage distribution system of claim 1, characterized in that said first regions (22) form the source region of MOSFET devices or the emitter region of bipolar transistors.

3. Voltage distribution system of claims 1 and 2, characterized in that said body of semiconductor material (10) and said polycrystalline material rows (32) and columns (28) are of n- or p-type silicon, and said insulating layer (12, 16) is of silicon dioxide.

4. Voltage distribution system of claims 1 to 3, characterized in that a fixed number of said first regions (22) are periodically disposed over the length of mutually isolated rectangular parallel regions (14) of the said body of semiconductor material each said first region (22) extending across the full width of the said regions (14) and interspaced with other similar second regions (46) of the same conductivity type, all such second regions (46) within a given row being interconnected by a metallic line (52), all of the third regions between said first (22) and second regions (46) being covered by a two-layer composite (44, 42) of insulating and polycrystalline semiconductor material, said polycrystalline layer forming continuous, parallel lines (42), orthogonal to said rows (32), each said third region in conjunction with adjacent first (22) and second regions (46) forming a MOSFET device.

5. Voltage distribution system of claim 4, characterized in that said two-layer composite (44, 42) is composed of silicon dioxide and polysilicon material.

6. Voltage distribution system of claim 4, characterized in that some of said MOSFETs are in a predetermined OFF condition obtained by selectively implanting a shallow layer of ionized impurities of the first conductivity type in said third regions.

## Patentansprüche

1. Spannungsverteilersystem (28, 32) eines LSI-Chips, bei dem in einem Körper als Halbleitermaterials (10) des ersten Leitfähigkeitstyps erste Bereiche (22) des zweiten Leitfähigkeitstyps an die Oberfläche angrenzend eingebracht sind und der von einer Isolierschicht (12, 16) bedeckt ist, die nicht zwingend eine einheitliche Schichtdicke aufweist, und in der Löcher (18), die bis zu den ersten Bereichen (22) reichen, angeordnet sind, dadurch gekennzeichnet, daß das Spannungsverteilersystem auf der Isolierschicht (12) aus Spalten (28) aus polykristallinen Halbleitermaterial des ersten Leitfähigkeitstyps besteht, welche eine Anzahl von Zeilen (32) aus polykristallinen Halbleitermaterial schneiden, wobei die Anzahl der Spalten und Zeilen und deren Periodizität nicht zwingend gleich sein müssen, und die metallische Verbindungen zu den Kontaktstellen am Umfang

5

aufweisen, und daß die Zeilen (32) und Spalten (28) teilweise oder vollständig die Löcher (18) bedecken, und dadurch einen elektrischen Kontakt zu den ersten Bereichen (22) bilden.

2. Spannungsverteilersystem nach Anspruch 1, dadurch gekennzeichnet, daß die ersten Bereiche (22) die Source des MOSFETs oder den Emitter bipolarer Transistoren bilden.

3. Spannungsverteilersystem nach den Ansprüchen 1 und 2, dadurch gekennzeichnet, daß der Körper aus Halbleitermaterial (10) und die Zeilen (32) und Spalten (28) aus polykristallinem Material aus N- oder P-leitendem Silicium sind und die Isolierschicht (12, 16) aus Siliciumdioxid besteht.

4. Spannungsverteilersystem nach Anspruch 1—3, dadurch gekennzeichnet, daß eine feste Anzahl der ersten Bereiche (22) periodisch über die Länge gegenseitig isolierter rechtwinkliger paralleler Bereiche (14) des Körpers aus Halbleitermaterial verteilt ist, wobei jeder der ersten Bereiche (22) sich über die volle Breite der Bereiche (14) erstreckt, und mit anderen ähnlichen zweiten Bereichen (46) des gleichen Leitfähigkeitstyps durchsetzt ist, und alle zweiten Bereiche (46) innerhalb einer gegebenen Zeile durch eine metallische Leitung (52) untereinander verbunden sind, und wobei alle dritten Bereiche zwischen den ersten Bereichen (22) und den zweiten Bereichen (46) von einer Doppelschicht (44, 42) aus isolierendem und polykristallinem Halbleitermaterial bedeckt sind, und wobei die polykristalline Schicht fortlaufende, parallele Leitungen (42) senkrecht zu den Zeilen (32) bildet, und jeder dritte Bereich zusammen mit benachbarten ersten Bereichen (22) und zweiten Bereichen (46) einen MOSFET bildet.

5. Spannungsverteilersystem nach Anspruch 4, dadurch gekennzeichnet, daß die Doppelschicht (44, 42) aus Siliciumdioxid und Polysiliciummaterial besteht.

6. Spannungsverteilersystem nach Anspruch 4, dadurch gekennzeichnet, daß einige der MOSFETS sich in einem bestimmten AUS-Zustand befinden, welcher dadurch erzielt wird, daß eine flache Schicht aus ionisierten Störstellen des ersten Leitfähigkeitstyps in die dritten Bereiche implantiert wird.

**Revendications**

1. Système de distribution de tension (28, 32) d'une puce à haut niveau d'intégration dans laquelle une zone de matière semiconductrice (10) du premier type de conductivité contient des premières régions (22) du second type de conductivité, contiguës à sa surface, et est recouverte par une couche isolante (12, 16) qui n'a pas nécessairement une épaisseur uniforme, cette couche comportant des trous (18) qui atteignent les premières régions (22), caractérisé en ce que ce système de distribution de tension disposé sur la couche isolante (12) est composé par un certain nombre de colonnes de matière semiconductrice polycristalline (28) du premier type de conductivité, croisant un ensemble de lignes de matière semiconductrice polycristalline (32), le nombre de colonnes et de lignes et leurs périodicités respectives n'étant pas nécessairement les mêmes, et les lignes et les colonnes comportant des connexions avec des plots périphériques, ces lignes (32) et ces colonnes (28) recouvrant partiellement ou complètement les trous (18) de façon à former un contact électrique avec les premières régions (22).

2. Système de distribution de tension selon la revendication 1, caractérisé en ce que les premières régions (22) forment la région de source de transistors à effet de champ MOS ou la région d'émetteur de transistors bipolaires.

3. Système de distribution de tension selon les revendications 1 et 2, caractérisé en ce que la zone de matière semiconductrice (10) et les lignes (32) et les colonnes (28) en matière polycristalline consistent en silicium de type n ou p, et la couche isolante (12, 16) consiste en dioxyde de silicium.

4. Système de distribution de tension selon les revendications 1 à 3, caractérisé en ce que des premières régions (22) en nombre fixe sont disposées périodiquement sur la longueur des régions parallèles rectangulaires (14) mutuellement isolées de la zone de matière semiconductrice, chacune de ces premières régions (22) s'étend sur toute la largeur desdites régions (14), avec des secondes régions similaires (46) du même type de conductivité intercalées entre les premières régions, toutes les secondes régions (46) dans une ligne donnée sont interconnectées par un conducteur métallique (52), toutes les troisièmes régions entre les première (22) et seconde (46) régions sont recouvertes par une structure composite à deux couches (44, 42) de matière isolante et de matière semiconductrice polycrystalline, la couche polycrystalline forme des conducteurs parallèles continus (42) orthogonaux aux lignes (32), et chaque troisième région forme un transistor à effet de champ MOS en association avec des première (22) et seconde (46) régions adjacentes.

5. Système de distribution de tension selon la revendication 4, caractérisé en ce que la structure composite à deux couches (44, 42) est formée par du dioxyde de silicium et du silicium polycristallin.

6. Système de distribution de tension selon la revendication 4, caractérisé en ce que certains des transistors à effet de champ MOS sont dans un état bloqué prédéterminé qui est obtenu par l'implantation sélective d'une couche superficielle d'impuretés ionisées du premier type de conductivité dans les troisièmes régions.

## FIG. 1A

12    14    12
10

## FIG. 1B

18    16    14    18    16    18
12    12
10

## FIG. 1C

18    26    18    18
20
12    12
16
24    22    24    22    24    22
10

FIG. 1D

FIG. 1E

0 031 539

FIG. 1F

FIG. 1G

FIG. 1 H

FIG. 2